# EUROPEAN PATENT APPLICATION

(11) **EP 4 764 564 A1**
(43) Date of publication of application: **24.06.2026**
(21) Application number: 25787059.2
(22) Date of filing: 01.04.2025
(51) Int. Cl.: G01R 31/396, G01R 31/3842, G01R 19/00, G01R 19/30, G01R 31/371, G01R 31/367

(54) **APPARATUS AND METHOD FOR GENERATING BATTERY PROFILE**

(30) Priority: 11.04.2024 KR 20240048649
(71) Applicant: LG Energy Solution, Ltd., Seoul 07335 (KR)
(72) Inventor: KIM, Tae-In, Daejeon 34122 (KR); BAE, Yoon-Jung, Daejeon 34122 (KR); SUN, Kyung-Eun, Daejeon 34122 (KR)
(74) Representative: Goddar, Heinz J.
(86) International application number: PCT/KR2025/004280
(87) International publication number: WO 2025/216467

(57) **Abstract**

The battery profile generating apparatus according to an embodiment of the present disclosure includes a profile obtaining unit configured to obtain a battery profile representing a corresponding relationship between a capacity and a voltage of a battery in a charging and discharging process and a current profile representing a time-dependent current change; and a control unit configured to set a reference value based on a plurality of current values included in the current profile, set a target current section among an entire current section included in the current profile based on the reference value, and filter the battery profile based on the time-dependent current change included in the target current section.

## Description

### TECHNICAL FIELD

This application is based on and claims priority from Korean Patent Application No. 10-2024-0048649, filed on April 11, 2024, with the Korean Intellectual Property Office, the disclosure of which is incorporated herein in its entirety by reference.

The present disclosure relates to a battery profile generating apparatus and method, and more particularly, to a battery profile generating apparatus and method, which generates a battery profile reflecting a state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

### DISCLOSURE

### Technical Problem

The present disclosure is designed to solve the problems of the related art, and therefore the present disclosure is directed to providing a battery profile generating apparatus and method, which more accurately reflects a state of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery profile generating apparatus according to one aspect of the present disclosure may comprise a profile obtaining unit configured to obtain a battery profile representing a corresponding relationship between a capacity and a voltage of a battery in a charging and discharging process and a current profile representing a time-dependent current change; and a control unit configured to set a reference value based on a plurality of current values included in the current profile, set a target current section among an entire current section included in the current profile based on the reference value, and filter the battery profile based on the time-dependent current change included in the target current section.

The control unit may be configured to set a target current section that includes current values lower than or equal to the reference value in the entire current section when the battery profile is a discharge profile, and filter the discharge profile based on the target current section.

The control unit may be configured to set a target current section that includes current values greater than or equal to the reference value in the entire current section when the battery profile is a charge profile, and filter the charge profile based on the target current section.

The control unit may be configured to filter the voltage by capacity included in the battery profile to correspond to the time-dependent current change included in the target current section.

The control unit may be configured to calculate a corrected voltage and a corrected capacity for each time based on the time-dependent current change included in the target current section, and filter the battery profile based on the corrected voltage and the corrected capacity.

The control unit may be configured to primarily filter the battery profile based on the time-dependent current change included in the target current section, and secondarily filter the primarily-filtered battery profile using a smoothing filter.

The control unit may be configured to set an average value, a median value, a mode value or a combination thereof of the plurality of current values included in the current profile as the reference value.

A battery pack according to another aspect of the present disclosure may comprise the battery profile generating apparatus according to one aspect of the present disclosure.

A vehicle according to another aspect of the present disclosure may comprise the battery profile generating apparatus according to one aspect of the present disclosure.

A battery diagnosing device according to still another aspect of the present disclosure may comprise a communication unit configured to obtain the battery profile generated by the battery profile generating apparatus according to one aspect of the present disclosure; and a processor configured to diagnose a state of the battery based on the battery profile obtained through the communication unit.

A battery profile generating method according to still another aspect of the present disclosure may comprise a profile obtaining step of obtaining a battery profile representing a corresponding relationship between a capacity and a voltage of a battery in a charging and discharging process and a current profile representing a time-dependent current change; a reference value setting step of setting a reference value based on a plurality of current values included in the current profile; a target current section setting step of setting a target current section among an entire current section included in the current profile based on the reference value; and a filtering step of filtering the battery profile based on the time-dependent current change included in the target current section.

### Advantageous Effects

According to one aspect of the present disclosure, the battery profile generating apparatus has an advantage of improving the accuracy of battery state diagnosis by more accurately generating a battery profile that may be used to diagnose the state of a battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating a battery profile generating apparatus according to an embodiment of the present disclosure.
FIG. 2 is a drawing schematically illustrating a battery profile according to an embodiment of the present disclosure.
FIG. 3 is a drawing schematically illustrating a current profile according to an embodiment of the present disclosure.
FIG. 4 and FIG. 5 are drawings illustrating a target current section included in the current profile of FIG. 3.
FIG. 6 and FIG. 7 are drawings schematically illustrating a filtered battery profile according to an embodiment of the present disclosure.
FIG. 8 is a drawing schematically illustrating a battery pack according to another embodiment of the present disclosure.
FIG. 9 is a drawing schematically illustrating a vehicle according to still another embodiment of the present disclosure.
FIG. 10 is a diagram schematically showing a battery profile generating method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

Also, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

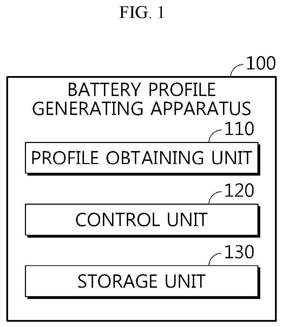

FIG. 1 is a diagram schematically illustrating a battery profile generating apparatus 100 according to an embodiment of the present disclosure.

Referring to FIG. 1, the battery profile generating apparatus 100 may include a profile obtaining unit 110 and a control unit 120.

The profile obtaining unit 110 may be configured to obtain a battery profile PB representing a corresponding relationship between a capacity and a voltage of a battery in a charging and discharging process, and a current profile PC representing a time-dependent current change.

Specifically, the battery profile PB may be a charge profile or a discharge profile.

For example, the battery profile PB is a charge profile that represents the corresponding relationship between the voltage (V) and the capacity (Q) when the SOC of the battery is charged from a preset charge start SOC or 0% to a preset charge end SOC or 100%. Here, the battery may be charged by repeating charging and discharging. That is, the battery may be charged as the charging current flows into the battery and the discharging current flows out from the battery according to the current pattern between the battery and the load.

As another example, the battery profile PB is a discharge profile that represents the corresponding relationship between the voltage (V) and the capacity (Q) when the SOC of the battery is discharged from a preset discharge start SOC or 100% to a preset discharge end SOC or 0%. Here, the battery may be discharged by repeating charging and discharging. That is, the battery may be discharged as the charging current flows into the battery and the discharging current flows out from the battery according to the current pattern between the battery and the load.

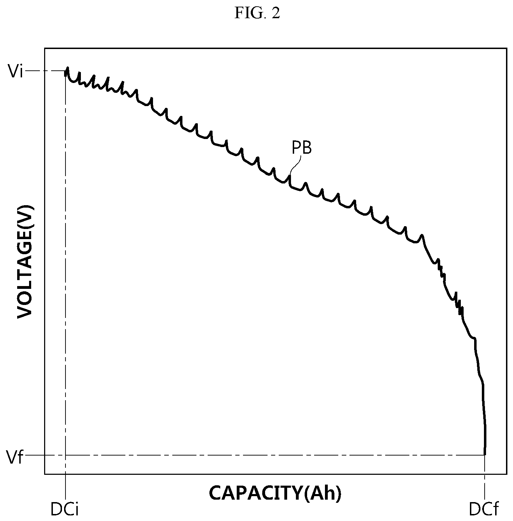

FIG. 2 is a drawing schematically illustrating a battery profile PB according to an embodiment of the present disclosure. Specifically, FIG. 2 is a diagram schematically illustrating a discharge profile of a battery.

Referring to FIG. 2, the capacity of the battery may decrease from the discharge start capacity (DCi) to the discharge end capacity (DCf). And, the voltage of the battery may decrease from the discharge start voltage (Vi) to the discharge end voltage (Vf). Here, since charging and discharging are performed in the discharging process of the battery, even if the capacity decreases, the voltage of the battery may not continuously decrease but may increase and decrease.

For example, assume that a battery is installed in an electric vehicle (EV). When the electric vehicle is in operation, the battery is basically discharged, but may be charged by regenerative braking, etc. That is, in the driving cycle in which the electric vehicle is operated, charging and discharging of the battery may also occur during the discharging process of the battery. In this case, the discharge profile for the battery may appear similar to the embodiment of FIG. 2.

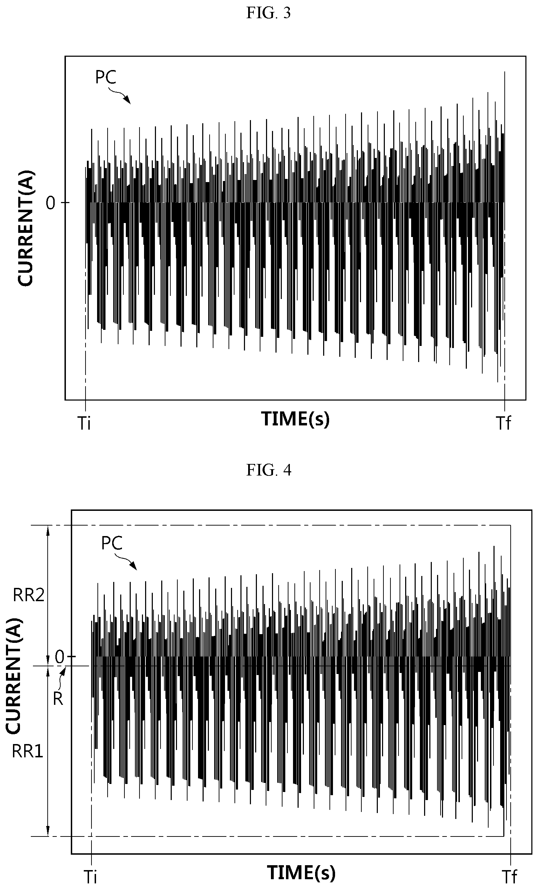

FIG. 3 is a drawing schematically illustrating a current profile PC according to an embodiment of the present disclosure. Specifically, the current profile PC of FIG. 3 may be a current profile PC corresponding to the battery profile PB of FIG. 2. That is, during the process of discharging the battery, the current change according to the time is represented by the current profile PC, and the voltage change according to the capacity is represented by the battery profile PB.

Referring to FIG. 3, the discharge of the battery may proceed from the discharge start time (Ti) to the discharge end time (Tf). And, in the discharging process of the battery, both the inflow of charging current (the size of the current exceeds 0) and the output of discharging current (the size of the current is less than 0) may occur.

In one embodiment, the profile obtaining unit 110 may directly receive the battery profile PB from the outside. That is, the profile obtaining unit 110 may obtain the battery profile PB by being connected to the outside by wire and/or wirelessly and receiving the battery profile PB.

In another embodiment, the profile obtaining unit 110 may receive battery information about voltage and capacity of the battery. Then, the profile obtaining unit 110 may generate a battery profile PB based on the received battery information. That is, the profile obtaining unit 110 may obtain the battery profile PB by directly generating the battery profile PB based on the battery information.

The profile obtaining unit 110 may be connected to communicate with the control unit 120. For example, the profile obtaining unit 110 may be connected to the control unit 120 by wire and/or wirelessly. The profile obtaining unit may transmit the obtained battery profile PB to the control unit 120.

The control unit 120 may be configured to set a reference value based on a plurality of current values included in the current profile PC.

Specifically, the current profile PC may include both a current whose size is greater than or equal to 0 and a current whose size is less than 0. Therefore, the control unit 120 may set a reference value that serves as a criterion for filtering the battery profile PB. That is, the reference value may mean a representative current value of the corresponding current profile PC.

For example, the control unit 120 may be configured to set a value calculated by an average value, a median value, a mode value, or a combination thereof of a plurality of current values included in the current profile PC as the reference value. As a specific example, the control unit 120 may set an average value, a median value, or a mode value of a plurality of current values as the reference value, or may set an average value of two or more of the average value, the median value, and the mode value as the reference value.

In the above, the average value, the median value, and the mode value are described as embodiments of the reference value, but any method of setting a reference value that can represent the current profile PC from a plurality of current values included in the current profile PC may be applied without limitation.

The control unit 120 may be configured to set a target current section RT among the entire current section included in the current profile PC based on the reference value.

Specifically, the control unit 120 may divide the current profile PC into a plurality of current sections based on the reference value. For example, when the reference value is set to 1, the current profile PC may be divided into two current sections centered on the reference value. In addition, the target current section RT may be set based on the type of the battery profile PB (charge profile or discharge profile).

For example, the control unit 120 may be configured to set a target current section RT that includes current values less than or equal to the reference value in the entire current section when the battery profile PB is a discharge profile.

As another example, the control unit 120 may be configured to set a target current section RT that includes current values greater than or equal to the reference value in the entire current section when the battery profile PB is a charge profile.

That is, since the battery profile PB is filtered based on the current value included in the target current section RT, the control unit 120 may set the target current section RT to correspond to the type of the battery profile PB.

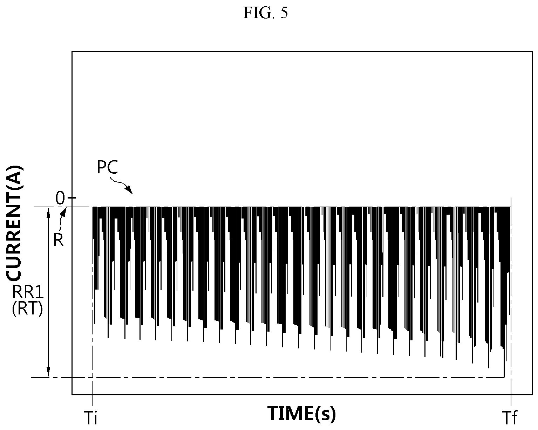

FIG. 4 and FIG. 5 are drawings illustrating a target current section RT included in the current profile PC of FIG. 3.

Specifically, in the embodiment of FIG. 4, the control unit 120 may set the reference value as an average value of a plurality of current values. Then, the control unit 120 may divide the entire current section of the battery profile PB into the first current section RR1 and the second current section RR2 based on the reference value. Then, since the battery profile PB of FIG. 2 is a discharge profile, the control unit 120 may set the first current section RR1 as the target current section RT.

The control unit 120 may be configured to filter the battery profile PB based on time-dependent current change included in the target current section RT.

Specifically, since the battery profile PB is a profile based on the time-dependent current change included in the entire current section, the control unit 120 may filter the battery profile PB based on the time-dependent current change included in the target current section RT.

More specifically, the control unit 120 may filter the battery profile PB so that only the time-dependent current change included in the target current section RT is reflected. For example, in the embodiment of FIGS. 4 and 5, the control unit 120 may filter the battery profile PB so that only the time-dependent current change included in the first current section RR1 is reflected. That is, the time-dependent current change included in the second current section RR2 may not be reflected in the filtered battery profile PB.

For example, the control unit 120 may be configured to primarily filter the battery profile PB based on the time-dependent current change included in the target current section RT to generate a filtered battery profile PB_f1.

After that, optionally, the control unit 120 may be configured to perform secondary filtering on the primarily-filtered battery profile PB_f1 using a smoothing filter to generate a filtered battery profile PB_f2. Here, the smoothing filter is a filter used to alleviate noise or smooth a trend of the battery profile PB, and a moving average, a kernel density estimation, and a Lowess (locally weighted scatterplot smoother) may be applied without limitation.

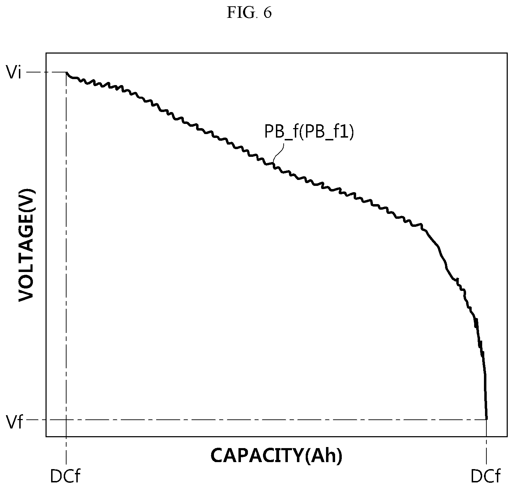

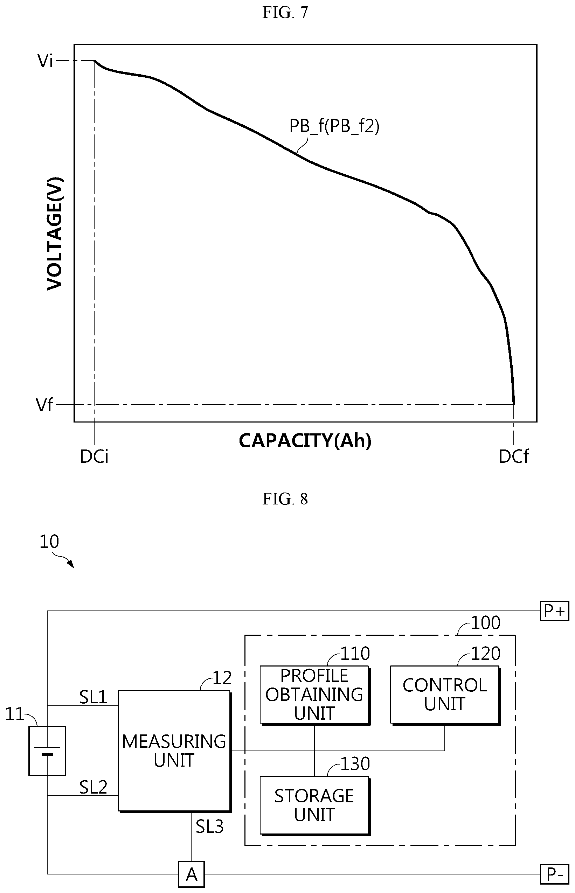

FIG. 6 and FIG. 7 are drawings schematically illustrating a filtered battery profile PB_f according to an embodiment of the present disclosure.

Specifically, the battery profile PB_f1 according to the embodiment of FIG. 6 is an embodiment in which the battery profile PB is primarily-filtered, and the battery profile BP_f2 according to the embodiment of FIG. 7 is an embodiment in which the primarily-filtered battery profile PB_f1 is secondarily-filtered.

The control unit 120 may remove noise included in the battery profile PB obtained by the profile obtaining unit 110 by filtering the battery profile PB based on the time-dependent current change included in the target current section RT. That is, a filtered battery profile PB_f1 may be generated based on the noise removal.

In addition, the control unit 120 may generate the battery profile PB_f2, which may more accurately represent the state of the battery, by smoothing the filtered battery profile PB_f1. Note that the secondary filtering process based on the smoothing filter may be omitted at the user's option.

The battery profile generating apparatus 100 according to an embodiment of the present disclosure may remove unnecessary noise included in the battery profile PB by limiting the current section according to the type of the battery profile PB. Therefore, the battery profile generating apparatus 100 may generate a battery profile PB_f that more accurately reflects the current state of the battery.

For example, the generated battery profile PB_f may more accurately represent the corresponding relationship between the capacity and voltage of the battery. Therefore, according to the generated battery profile PB_f, the SOX (State of x) such as the SOC (state of charge), SOH (state of health), and SOP (state of power) of the battery may be estimated more accurately. As a result, the battery profile generating apparatus 100 has an advantage of improving the accuracy of battery state diagnosis by more accurately generating the battery profile PB_f that may be used to diagnose the state of the battery.

Meanwhile, the profile obtaining unit 110 and the control unit 120 included in the battery profile generating apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110 and the control unit 120 may be implemented as a set of program modules. At this time, the program module may be stored in the memory and executed by the profile obtaining unit 110 and the control unit 120. The memory may be inside or outside the profile obtaining unit 110 and the control unit 120 and may be connected to the profile obtaining unit 110 and the control unit 120 by various well-known means.

In addition, the battery profile generating apparatus 100 may further include a storage unit 130. The storage unit 130 may store data necessary for operation and function of each component of the battery profile generating apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile obtaining unit 110 and the control unit 120 are defined.

For example, the storage unit 130 may store the battery profile PB, the current profile PC, and the smoothing filter. In addition, the storage unit 130 may also store the battery profiles PB_f1, PB_f2 filtered by the control unit 120.

Below, an embodiment in which the control unit 120 filters the battery profile PB is described in more detail.

The control unit 120 may be configured to filter the voltage by capacity included in the battery profile PB to correspond to the time-dependent current change included in the target current section RT.

Specifically, the control unit 120 may be configured to calculate a corrected voltage and a corrected capacity for time, respectively, based on the time-dependent current change included in the target current section RT.

For example, the voltage and capacity included in the battery profile PB obtained by the profile obtaining unit 110 are based on the time-dependent current change included in the entire current section. That is, the corresponding relationship between the voltage and capacity based on the time-dependent current change in the entire current section appears in the battery profile PB. In this case, the voltage and capacity based on the current value (noise) that does not correspond to the type (charge profile or discharge profile) of the battery profile PB may also be included in the battery profile PB. Therefore, the control unit 120 may calculate the corrected voltage and the corrected capacity based on the time-dependent current change in the target current section RT.

For example, in the embodiments of FIGS. 2 and 4, the voltage and capacity shown in the battery profile PB of FIG. 2 are based on the current values included in the first current section RR1 and the second current section RR2. Here, since the battery profile PB is a discharge profile, the current value included in the second current section RR2 may be noise. Therefore, the control unit 120 may calculate the time-dependent voltage change and the time-dependent capacity change based on the current value included in the first current section RR1.

Additionally, the control unit 120 may be configured to filter the battery profile PB based on the corrected voltage and the corrected capacity.

Specifically, the control unit 120 may filter the battery profile PB to display the corresponding relationship between capacity and voltage by matching the generated time-dependent voltage change with the time-dependent capacity change.

For example, the control unit 120 may filter the battery profile PB according to the embodiment of FIG. 2 to generate the battery profile PB_f1 according to the embodiment of FIG. 6. Furthermore, the control unit 120 may further filter the battery profile PB_f1 according to the embodiment of FIG. 6 to generate the battery profile PB_f2 according to the embodiment of FIG. 7.

The battery profile generating apparatus 100 according to the present disclosure may be applied to a battery management system (BMS). That is, the BMS according to the present disclosure may include the battery profile generating apparatus 100 described above. In this configuration, at least some of components of the battery profile generating apparatus 100 may be implemented by supplementing or adding functions of the components included in a conventional BMS. For example, the profile obtaining unit 110, the control unit 120 and the storage unit 130 of the battery profile generating apparatus 100 may be implemented as components of the BMS.

Additionally, the battery profile generating apparatus 100 according to the present disclosure may be provided in the battery pack. That is, the battery pack according to the present disclosure may include the above-described battery profile generating apparatus 100 and at least one battery cell. Additionally, the battery pack may further include electrical components (relays, fuses, etc.) and a case.

FIG. 8 is a diagram showing a battery pack according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

For example, the profile obtaining unit 110 may receive battery information about the voltage and current of the battery from the measuring unit 12. Then, the profile obtaining unit 110 may generate a battery profile PB based on the battery information.

As another example, the profile obtaining unit 110 may receive a battery profile PB from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

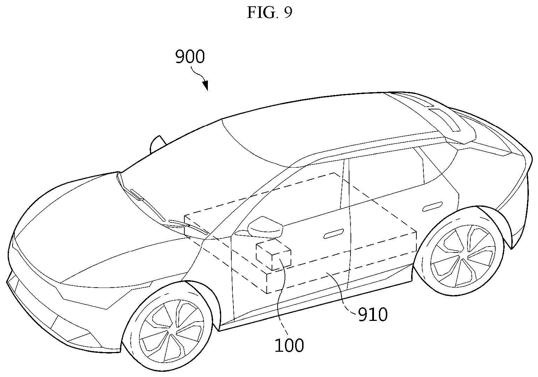

FIG. 9 is a drawing schematically illustrating a vehicle 900 according to another embodiment of the present disclosure.

Referring to FIG. 9, the battery pack 910 according to an embodiment of the present disclosure may be included in a vehicle 900, such as an electric vehicle (EV) or a hybrid vehicle (HV). In addition, the battery pack 910 may drive the vehicle 900 by supplying power to a motor through an inverter provided in the vehicle 900. Here, the battery pack 910 may include the battery profile generating apparatus 100. That is, the vehicle 900 may include the battery profile generating apparatus 100. In this case, the battery profile generating apparatus 100 may be an onboard device included in the vehicle 900.

For example, the battery profile generating apparatus 100 may generate a battery profile PB_f that more accurately reflects the state of the battery pack 910 by filtering the battery profile PB obtained from the battery pack 910 in the charging or discharging process.

A battery diagnosing device (not shown) according to another embodiment of the present disclosure may include a communication unit and a processor.

The communication unit may be configured to obtain a battery profile PB_f generated by the battery profile generating apparatus 100.

For example, the communication unit may be wired and/or wirelessly connected to communicate with the battery profile generating apparatus 100. And, the communication unit may receive the filtered battery profile PB_f from the battery profile generating apparatus 100.

As another example, the communication unit may be wired and/or wirelessly connected to communicate with a third party device other than the battery profile generating apparatus 100. And, the communication unit may receive the filtered battery profile PB_f from the third party device.

The processor may be configured to diagnose the state of the battery based on the battery profile PB_f obtained through the communication unit.

Specifically, the filtered battery profile PB_f is a noise-removed profile, which may more accurately represent the state of the battery. Therefore, the processor may estimate the SOX of the battery more accurately based on the filtered battery profile PB_f. In other words, the state of the battery may be diagnosed more accurately.

In addition, the battery diagnosing device may increase the expected life of the battery by setting the usage conditions for the battery to correspond to the estimated state of the battery. For example, the battery diagnosing device may change the usage conditions for the battery, such as the threshold temperature, the threshold SOC, the threshold voltage, and the threshold C-RATE.

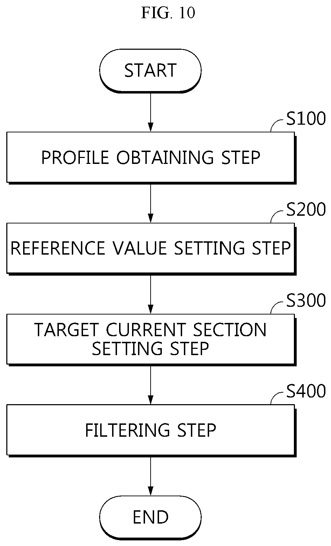

FIG. 10 is a diagram schematically showing a battery profile generating method according to still another embodiment of the present disclosure.

Referring to FIG. 10, the battery profile generating method may include a profile obtaining step (S100), a reference value setting step (S200), a target current section setting step (S300), and a filtering step (S400).

Preferably, each step of the battery profile generating method may be performed by the battery profile generating apparatus 100. Hereinafter, for convenience of explanation, contents overlapping with the previously described contents will be omitted or briefly described.

The profile obtaining step (S100) is a step of obtaining a battery profile PB representing a corresponding relationship between a capacity and a voltage of a battery in a charging and discharging process and a current profile PC representing a time-dependent current change, and may be performed by the profile obtaining unit 110.

In one embodiment, the profile obtaining unit 110 may directly receive the battery profile PB of the battery from the outside. That is, the profile obtaining unit 110 may obtain the battery profile PB by being connected to the outside by wire and/or wirelessly and receiving the battery profile PB.

In another embodiment, the profile obtaining unit 110 may receive battery information about voltage and capacity of the battery. Then, the profile obtaining unit 110 may generate a battery profile PB based on the received battery information. That is, the profile obtaining unit 110 may obtain the battery profile PB by directly generating the battery profile PB based on the battery information.

The reference value setting step (S200) is a step of setting a reference value based on a plurality of current values included in the current profile PC, and may be performed by the control unit 120.

Here, the reference value may mean a representative current value of the corresponding current profile PC.

For example, the control unit 120 may be configured to set a value calculated by an average value, a median value, a mode value, or a combination thereof of a plurality of current values included in the current profile PC as the reference value. As a specific example, the control unit 120 may set an average value, a median value, or a mode value of a plurality of current values as the reference value, or may set an average value of two or more of the average value, the median value, and the mode value as the reference value.

The target current section setting step (S300) is a step of setting a target current section RT among an entire current section included in the current profile PC based on the reference value, and may be performed by the control unit 120.

For example, the control unit 120 may be configured to set a target current section RT that includes current values less than or equal to the reference value in the entire current section when the battery profile PB is a discharge profile.

As another example, the control unit 120 may be configured to set a target current section RT that includes current values greater than or equal to the reference value in the entire current section when the battery profile PB is a charge profile.

The filtering step (S400) is a step of filtering the battery profile PB based on the time-dependent current change included in the target current section RT, and may be performed by the control unit 120.

For example, the control unit 120 may be configured to primarily filter the battery profile PB based on the time-dependent current change included in the target current section RT to generate a filtered battery profile PB_f1. Optionally, the control unit 120 may be configured to secondarily filter the primarily-filtered battery profile PB_f1 using a smoothing filter to generate a filtered battery profile PB_f2.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
12: measuring unit
100: battery profile generating apparatus
110: profile obtaining unit
120: control unit
130: storage unit
900: vehicle
910: battery pack

## Claims

1. A battery profile generating apparatus, comprising:
a profile obtaining unit configured to obtain a battery profile representing a corresponding relationship between a capacity and a voltage of a battery in a charging and discharging process and a current profile representing a time-dependent current change; and
a control unit configured to set a reference value based on a plurality of current values included in the current profile, set a target current section among an entire current section included in the current profile based on the reference value, and filter the battery profile based on the time-dependent current change included in the target current section.

2. The battery profile generating apparatus according to claim 1,
wherein the control unit is configured to set a target current section that includes current values lower than or equal to the reference value in the entire current section when the battery profile is a discharge profile, and filter the discharge profile based on the target current section.

3. The battery profile generating apparatus according to claim 1,
wherein the control unit is configured to set a target current section that includes current values greater than or equal to the reference value in the entire current section when the battery profile is a charge profile, and filter the charge profile based on the target current section.

4. The battery profile generating apparatus according to claim 1,
wherein the control unit is configured to filter the voltage by capacity included in the battery profile to correspond to the time-dependent current change included in the target current section.

5. The battery profile generating apparatus according to claim 4,
wherein the control unit is configured to calculate a corrected voltage and a corrected capacity for each time based on the time-dependent current change included in the target current section, and filter the battery profile based on the corrected voltage and the corrected capacity.

6. The battery profile generating apparatus according to claim 1,
wherein the control unit is configured to primarily filter the battery profile based on the time-dependent current change included in the target current section, and secondarily filter the primarily-filtered battery profile using a smoothing filter.

7. The battery profile generating apparatus according to claim 1,
wherein the control unit is configured to set an average value, a median value, a mode value or a combination thereof of the plurality of current values included in the current profile as the reference value.

8. A battery pack, comprising the battery profile generating apparatus according to any one of claims 1 to 7.

9. A vehicle, comprising the battery profile generating apparatus according to any one of claims 1 to 7.

10. A battery diagnosing device, comprising:
a communication unit configured to obtain the battery profile generated by the battery profile generating apparatus according to any one of claims 1 to 7; and
a processor configured to diagnose a state of the battery based on the battery profile obtained through the communication unit.

11. A battery profile generating method, comprising:
a profile obtaining step of obtaining a battery profile representing a corresponding relationship between a capacity and a voltage of a battery in a charging and discharging process and a current profile representing a time-dependent current change;
a reference value setting step of setting a reference value based on a plurality of current values included in the current profile;
a target current section setting step of setting a target current section among an entire current section included in the current profile based on the reference value; and
a filtering step of filtering the battery profile based on the time-dependent current change included in the target current section.
